Europäisches Patentamt

European Patent Office

Office européen des brevets

(19)

(11) EP 1 170 860 A1

(12) EUROPEAN PATENT APPLICATION

(43) Date of publication:
09.01.2002 Bulletin 2002/02

(51) Int Cl.⁷: H03G 3/20, H03F 1/32

(21) Application number: 00401835.4

(22) Date of filing: 27.06.2000

(84) Designated Contracting States:
AT BE CH CY DE DK ES FI FR GB GR IE IT LI LU
MC NL PT SE
Designated Extension States:
AL LT LV MK RO SI

(71) Applicant: Nortel Matra Cellular
78928 Guyancourt Cédex 9 (FR)

(72) Inventors:
• Calmel, Pierre Emmanuel
F-75016 Paris (FR)

• Jacques, Roger
F-78320 Levis Saint Nom (FR)
• Pidancier, Christian
F-91640 Briis sous Forges (FR)
• Fabrice, Robert
F-78180 Montigny le Bretonneux (FR)
• Georgeaux, Eric
78180 Montigny le Bretonneux (FR)

(74) Representative: Bird, William Edward et al
Bird Goen & Co., Vilvoordsebaan 92
3020 Winksele (BE)

(54) **Improved multi-carrier receiver for radio telecommunications network**

(57) A multi-carrier receiver for a radio telecommunications network is described, comprising a downconverter for downconverting a received analog radio frequency signal to an intermediate frequency (IF) signal; a control unit for controlling the power level of the IF signal; a coupler for coupling a representative value of the IF signal to the control unit; a delay element located downstream of the coupler for delaying the propagation of the IF signal to an electronic component, the control unit controlling the power level of the IF signal by feed forward control to keep this IF power level within a dynamic range of the electronic component. The electrical component is preferably a first analog to digital converter (ADC). The control unit preferably comprises a log amplifier and a second ADC. The delay element is preferably a filter or a delay line. The control unit preferably controls the frequency bandwidth of the IF signal so that at least a portion of the energy from an interferer lies outside the frequency bandwidth of the IF signal. The control unit is preferably adapted to adjust the operation of a local oscillator. To achieve this, the multi-carrier receiver preferably includes a device for estimating the frequency of an interferer. The device preferably estimates the frequency from the most significant bit of the output of the first ADC.

Fig. 2

## Description

The present invention relates to wireless telecommunication networks as well as satellite systems, particularly wireless Local Area Networks (LAN) and Metropolitan Area Networks (MAN) which are subject to interference. The present invention also relates to multi-carrier receivers in such systems and methods of operating the same.

## TECHNICAL BACKGROUND

Wireless communication networks may be divided into two basic sorts. The older networks are often referred to as "narrowband" with respect to the radio spectrum of the air interface. The radio spectrum is limited to a single carrier. Typically, a narrowband transceiver comprises a receiver, a transmitter and a single carrier power amplifier. Some modem networks as described, for instance, in "Wideband CDMA for Third Generation Mobile Communications", Ojanperä and Prasad, Artech house, 1998 are termed "wideband". Wideband air interfaces typically have a bandwidth of 5 Mhz. However, in order to provide backwards compatibility wideband transceivers may also be configured for receiving a plurality of "narrowband" carriers. Such a transceiver is known as a multi-carrier transceiver.

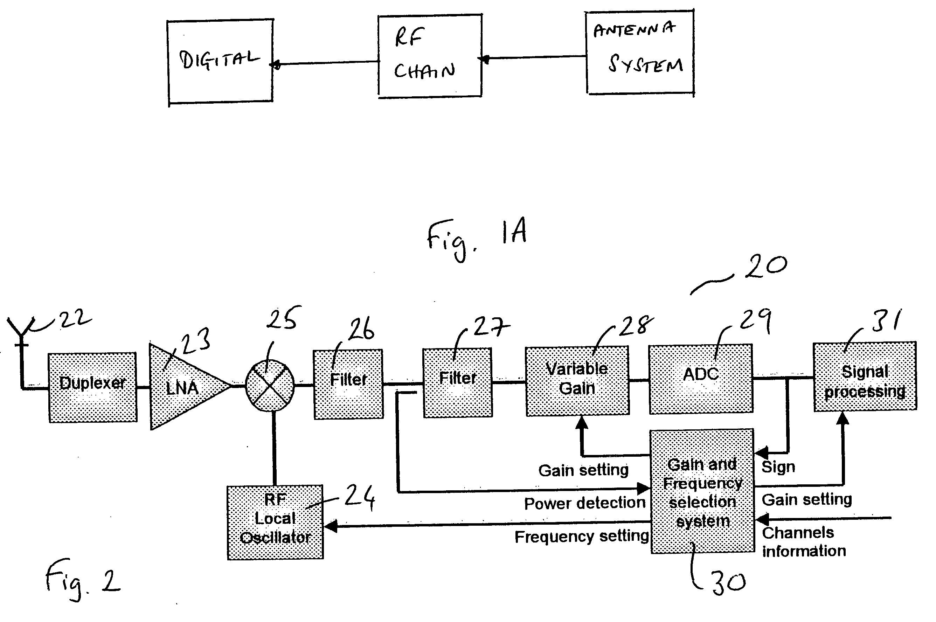

A generic wideband multi-carrier receiver is shown schematically in Figs. 1A and B with the input from the antennas on the right. The receiver basically consists of three parts: an antenna system, a radio frequency chain and the digital section (Fig. 1A).

The receiver comprises a plurality of chanelizers 1-1 ... 1-n, one per carrier, which each perform channel tuning, filtering and decimation required to provide baseband I and Q signals for subsequent digital signal processing (Fig. 1B). Typically two sets of channelizers 1-1 ....1-n and 2-1 .... 2-n chanelize inputs from a main and a diversity antenna. The analog side of the receiver comprises a radio frequency downconverter 11, 12, 14 and an intermediate frequency downconverter 7, 8, 13 as well as the required filters 9, 10 and 5, 6 respectively. In addition analog to digital converters (ADC) 3, 4 convert the analog signals to digital signals before chanelization.

In case of a high power interferer which is in the frequency band processed by the receiver, the received high power signal can seriously disturb the behavior of one of the components of the RF chain, particularly the ADC. If the received signal power goes beyond the dynamic range (over-ranges) of this component, e.g. the ADC, the recovery to normal operation can take some time. Even if the ADC is not over-ranged the power level difference between the interferer and useful signals from other users of the network may be so large that the wanted signals sink below the noise level of the receiver. In such a case, severe signal degradation will occur. Interferers may be coordinated or uncoordinated.

A coordinated interferer belongs to the telecommunications network with which it is interfering. Typically, a coordinated interferer will be a mobile terminal using an access channel at a very high power level, that is before the mobile terminal has logged onto the system and before power control is initiated. An uncoordinated interferer is an interferer which is not under control of the network. Such an interferer may be a long term problem as there may be no way of controlling its power level.

Particularly troublesome are intermittent interferers, e.g. blinking interferers or bursty interferers such as a high power request on a random access channel. These may defeat normal interferer protection, at least initially.

Interferer signals may be described by the formula:

$$A \cos(\omega T + \varphi(t))$$

where $\omega$ is $2\pi$ time the frequency of transmission and $\varphi$(t) contributes what is known as "phase noise".

When the ADC is over-ranged it may take quite some time to recover. Various solutions are possible to combat this problem. Some of these methods have been described in US 5,955,987.

Firstly, it is possible to use channel filters to break down the multi-carrier analog signal into individual narrow band carriers and then to process each single carrier in conventional ways. This does not make use of the advantage provided by multi-carrier transmission.

Secondly, it is possible to re-inject a signal upstream of the ADC to eliminate the interferer by cancellation. This may be done by feeding the signal from the ADC to a digital analog converter (DAC), and re-injecting a negative value by subtracting the interferer peak from the input signal before the ADC. The disadvantage of this system is that the DAC not only injects the interferer canceling signal but also noise. This noise may be of such high power that the signal quality of wanted signals from other mobiles is seriously impaired.

Alternatively, if the interferer is a pure sinusoidal transmitter, a voltage controlled oscillator could be tuned to the frequency, phase and amplitude of the interferer and a canceling signal injected into the input signal. There are practical difficulties in obtaining a good canceling signal by this method.

Alternatively, a tunable notch filter could be tuned to the interferer frequency to filter out the interferer exclusively. However, there are difficulties in obtaining a tunable notch filter with narrow bandwidth.

It is an object of the present invention to provide a multi-carrier receiver in a radio telecommunications system and a method of operating the same which reduces disturbances to operation caused by high power interferers.

## SUMMARY OF THE INVENTION

In one aspect of the present invention use is made of feed forward control to limit the gain of the RF chain of a mult-icarrier receiver.

The present invention provides a multi-carrier receiver for a radio telecommunications network, comprising: a downconverter for downconverting a received analog radio frequency signal to an intermediate frequency (IF) signal; a control unit for controlling the power level of the IF signal; a coupler for coupling a representative value of the IF signal to the control unit; a delay element located downstream of the coupler for delaying the propagation of the IF signal to an electrical component, the control unit controlling the power level of the IF signal by feed forward control to keep this IF power level within a dynamic range of the electrical component. The electrical component is preferably a first analog to digital converter (ADC). The control unit preferably comprises a log amplifier and a second ADC. The delay element is preferably a filter or a delay line. The control unit preferably controls the frequency bandwidth of the IF signal so that at least a portion of the energy from an interferer lies outside the frequency bandwidth of the IF signal. The control unit is preferably adapted to adjust the operation of a local oscillator. To achieve this, the multi-carrier receiver preferably includes a device for estimating the frequency of an interferer. The device preferably estimates the frequency from the most significant bit of the output of the first ADC.

The present invention provides a method of controlling the operation of a multi-carrier receiver for a radio telecommunications network, the method comprising the steps of: downconverting a received analog radio frequency signal to an intermediate frequency (IF) signal; controlling the power level of the IF signal; delaying the propagation of the IF signal to a downstream electrical component, the controlling step controlling the power level of the IF signal by feed forward control to keep this IF power level within a dynamic range of the electrical component. The method may further comprise the step of controlling the frequency bandwidth of the IF signal so that at least a portion of the energy from an interferer lies outside the frequency bandwidth of the IF signal. The method further comprises the step of estimating the frequency of the interferer from the output of an ADC.

The present invention will now be described with reference to the following drawings.

## BRIEF DESCRIPTIONS OF THE DRAWINGS

Figs. 1A is a schematic block diagram of a receiver of a type for use with the present invention.

Fig. 1B shows more details of the receiver of Fig. 1.

Fig. 2 is a schematic representation of a receiver in accordance with an embodiment of the present invention;

Fig. 3 is a schematic representation of details of the feed forward control system of an embodiment of the present invention.

Fig. 4 is a graph showing the results for a conventional narrow band receiver (42) compared with a multi-channel receiver in accordance with an embodiment of the present invention (43) and that required by the GSM ETSI standards when the interferer is a pure sine wave and is coordinated.

Fig. 5 is a graph showing the results for a conventional narrow band receiver (42) compared with a multi-channel receiver in accordance with an embodiment of the present invention (43) and that required by the GSM ETSI standards when the interferer is a pure sine wave and is uncoordinated.

Fig. 6 is a graph showing the results for a conventional narrow band receiver (42) compared with a multi-channel receiver in accordance with an embodiment of the present invention (43) and that required by the GSM ETSI standards when the interferer includes phase noise and is coordinated.

Fig. 7 is a graph showing the results for a conventional narrow band receiver (42) compared with a multi-channel receiver in accordance with an embodiment of the present invention (43) and that required by the GSM ETSI standards when the interferer includes phase noise and is uncoordinated.

## DESCRIPTION OF THE ILLUSTRATIVE EMBODIMENTS

The present invention will be described with reference to certain embodiments and with reference to certain drawings but the present invention is not limited thereto but only by the claims. In particular the present invention will mainly be described with reference to cellular mobile telephone systems but the present invention is not limited thereto. For instance, the present invention may be advantageously used in wireless local area networks (LAN) or Metropolitan Access Networks. Various types of wireless LAN have been standardized or are in general use, e.g. the standards IEEE 802.11, IEEE 802.11HR (Spread Spectrum) and systems based on DECT, Blue Tooth, HIPERLAN. Wireless LAN's are discussed in detail in "Wireless LAN's" by Jim Geier, Macmillan Technical Publishing, 1999.

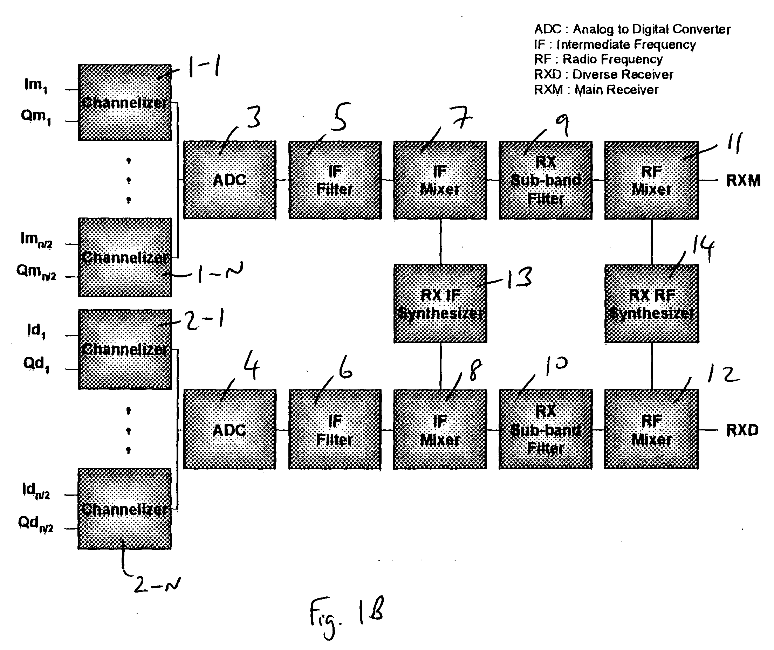

A wideband receiver 10 in accordance with an embodiment of the present invention is shown schematically in Fig. 2. The wideband receiver 10 may be, for instance, part of a base station transceiver (BTS) of any of the wideband radio telecommunications systems described in the book by Ojanperä and Prasad mentioned above. Receiver 10 is a multi-carrier receiver which is adapted to also receive narrow band carriers, e.g. it is part of a receiver in a dual band system such as a UMTS and GSM system. The sensitivity and the dynamic range of wideband receiver 10 is mainly a function of RF chain parameters such as the gain G, the Noise Factor, NF which is a function f(G) of the gain and the phase noise of the base station transceiver (BTS) VCO, $N_{BTS}$, as well as parameters of the analog to digital converter ADC such as full scale input power, $P_{fs}$ signal to noise ratio, SNR and the sampling rate used for conversion of the analog signals into digital ones, Fsamp. Further factors are the mobile station parameters such as the maximum interferer input level, $I_{max}$, the interferer phase noise, $N_{interferer}$ as well as signal processing parameters such as the sensitivity Eb/No, Eb/No and the Symbol rate, $F_{Symb}$.

One aspect of the present invention is to dynamically optimize the signals entering a particular component of the RF chain e.g. the ADC, in order to prevent over-ranging of thereof. In accordance with an embodiment of the present invention this is achieved by adjusting the RF chain gain to an optimum value in a feed forward manner so that the component, e.g. the ADC, is not over-ranged. An optimum value is preferably the value for which the RF chain gain G is equal to the difference between the allowable input full scale power of the component and the RF chain input instantaneous power (including the interferer). By keeping the gain at this level or slightly lower, the component operation will remain within the allowable full scale power and the useful signals will be amplified to their maximum extent without distortion due to over-ranging of components in the RF chain. Keeping to this value provides a significant advantage, for example for currently available ADC's. By keeping the ADC operation within its allowed limits the ADC provides a good signal for later digital signal processing. Of course, the interferer signal is still present so that there is no reduction in the interferer power level to mobile terminal power levels but with sensitive downstream equipment this disadvantage can be partly obviated provided there is no distortion of the weak wanted signals in the RF chain. Thus, in accordance with one aspect of the present invention, especially for coordinated interferers, it is preferred if the amplified power level in the RF chain is within certain limits even if this means that the useful signal power is low, because at these power levels the amplification of the weak useful signals is still distortion-free so that with good downstream equipment a useful signal can still be recovered.

In addition the frequency of a local downconverting oscillator upstream of the ADC is preferably adjusted to be as close as possible to an optimum value. The optimum value is the one which minimizes the amount of non-coordinated interfering signal level which enters the ADC. Hence, in accordance with another aspect of the present invention, it is preferred if a frequency band containing a significant amount of interferer signal energy is exclude from the useful frequency band for communications.

An embodiment of a receiver 20 in accordance with the present invention is shown schematically in Fig. 2. It comprises a receive antenna 22, feeding a low noise amplifier 23. The received analog signal is downconverted to an intermediate frequency (IF) by multiplying the received signal with a signal from a tunable RF local oscillator 24 in a multiplier 25. The extracted IF analog signal is then passed through a first optional filter 26 which is typically a SAW (surface acoustic wave) filter. The signal is then passed to a second filter 27 (optionally a SAW filter) and then through an attenuator or variable gain amplifier 28 to a first analog to digital converter (ADC) 29 before going to further signal processing circuits 31. In addition a gain and frequency control module 30 is provided.

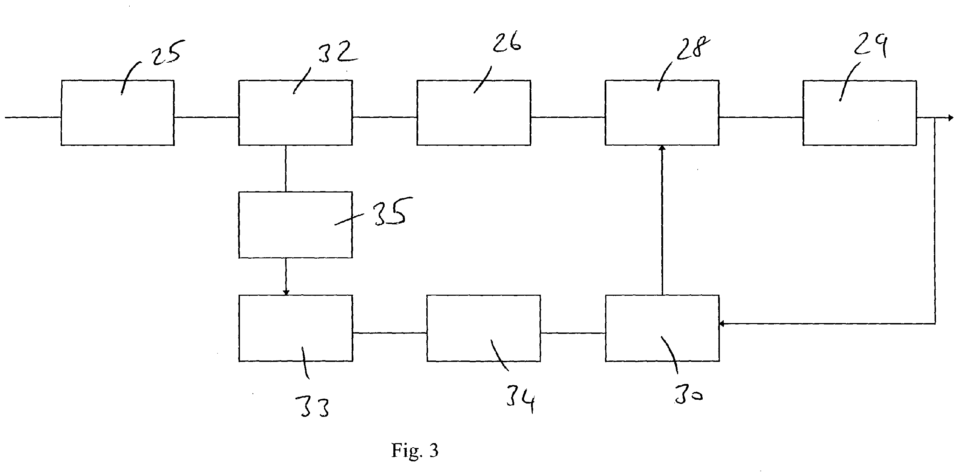

The receiver 20 has a dual loop control system. The first loop has an immediate response time and controls the gain and is shown in more detail in Fig. 3. One purpose of the gain and frequency control module 30 is to select the optimum gain for the RF chain in face of an in-band coordinated interferer. The system works on the feedforward principle. The power detection chain is shown in Fig. 3 and comprises a coupler 32, an optional delay line 35, a log amplifier 33 and a second ADC 34. The coupler 32 delivers a representative portion of the received signal to the log amplifier 33. The output of the log amplifier 33 is representative of the power envelope of the IF signal in logarithmic units. This output is fed to an ADC 34 which may be, for instance, an 8-bit ADC. The output of the ADC is a digital value providing a logarithmic representation of the power envelope of the IF signal. If this value exceeds a value equivalent to the logarithmic value of the dynamic range of the ADC 29, the ADC 29 will be over-ranged if this signal is allowed to reach the ADC 29. Hence, responsive to the value output by ADC 34, the gain and frequency control module 30 sends an appropriate signal to attenuator 28 which then reduces the amplitude of the IF signal to keep the signal within the dynamic range of ADC 29.

The gain selection system may be implemented as a log amplifier 33, an 8 bits ADC 34, the gain and frequency control module 30 implemented as a Field Programmable Gate Array (FPGA) and a 3 bits digital attenuator 28. The attenuator 28 may provide steps of attenuation, e.g. 0, 6, 12, 18 and 24 dB attenuation. The advantage of using a 6 dB multiple is that usual receive channelizers have mantissa and exponent interface whereby the exponent corresponds to 6 dB shifts.

For this system to work effectively, the feed forward control must be faster than the time taken for the IF signal to traverse the second filter 27. The second filter 27 acts as a delay element which delays propagation of signals for a sufficient time for the attenuator adjusting system to alter the attenuator setting. The present invention includes other delay elements, such as for instance a delay line. The delay in the control loop is equal to :

- The coupler propagation delay (supposed negligible)
- The log amplifier propagation delay (for example, around 15 ns rise time for and AD8310)

• The delay of ADC 34 (for example, 4 clock periods for an AD9288).

The RF chain has a propagation delay between the coupler 32 and the attenuator 28 which is equal to the group delay of the second IF filter 27 which may be 150 ns up to 1 microsecond. To work as a feedforward system, the difference between the second IF filter group delay and the overall control loop propagation delay has to provide enough time margin for the gain and frequency control module 30 to make the appropriate selection and for the attenuator to adjust. Hence, the present invention includes the use of a delay element such as a filter to allow time for a gain selection control device to keep the power level of the signal within the dynamic range of the ADC 29. The optional delay line 35 may be used to adjust the time of operation of the attenuator 28 so that there is a minimum of time between the arrival of an interferer signal at the attenuator 28 via filter 26 and the adjustment of attenuator 28. The delay line 35 should be dimensioned so as to minimize the time that normal signals ahead of an interferer signal are excessively attenuated. Similarly, once an interferer burst has passed attenuator 28, the attenuator 28 should return to normal amplification levels as soon as possible. Ideally, the first control loop should be designed so that the attenuator 28 acts slightly faster when increasing the attenuation than when reducing the attenuation. This reduces the possibility that the attenuator 28 reduces attenuation while the end of an interferer burst is still passing through the attenuator 28. Over amplification of an interferer burst could over-range the ADC 29. Instead of using a delay line 35, the necessary delays may be provided by control unit 30 delaying the activation of an attenuation change as required.

The second loop in the control system in accordance with an embodiment of the present invention aims at minimizing the overall out-of-band uncoordinated interfering signal power level. Consequently, if unwanted power in other frequency ranges can be excluded from the useful range, the attenuation level required to keep the ADC 29 within its allowed dynamic range can be reduced. In accordance with this embodiment of the present invention the sign output (most significant bit) of ADC 29 is used to provide a simple frequency estimator for the highest received signal (assumed to be the interferer). The number of sign changes during a fixed period of time gives a good estimate of the dominating interferer frequency Fin:

$$Fin = F_{OLRF} + F_{OLIF} + Sign_{toggles}/Nb_{samples} * F_{ech}/2$$

in which $F_{OLRF}$ is the RF local oscillator frequency, $F_{OLIF}$ is the intermediate local oscillator frequency, $Sign_{toggles}$ is the number of sign bit toggles (changes) during the measurement period, $Nb_{samples}$ is the number of samples in the measurement period and $F_{ech}$ is the sampling frequency.

Several estimations may be performed over one burst. This provides an indication on the measurement validity. It can be used as a detector (combined with the envelope power detector) of a radium access channel RACH.

The measured frequency is compared to the frequency set of the cells in gain and frequency control module 30. If the measured frequency is outside the allocated band of the RF module and this is measured several times, the RF local oscillator frequency is modified in order to optimize the rejection of uncoordinated frequencies and to minimize the attenuation level required for the system and consequently improve the overall BTS sensitivity and blocking performance. As we are dealing with out-of-band signaling for the relevant cell, the oscillator 24 may be adjusted to move the IF band to exclude the interferer. The gain and frequency control module 30 sends an appropriate message to the oscillator 24 in this case which modifies its output accordingly.

On the other hand if the frequency lies within the frequency set of the cells then the interferer is in-band and the control is performed by keeping the ADC input within the dynamic range of the ADC 29 as described above.

Examples

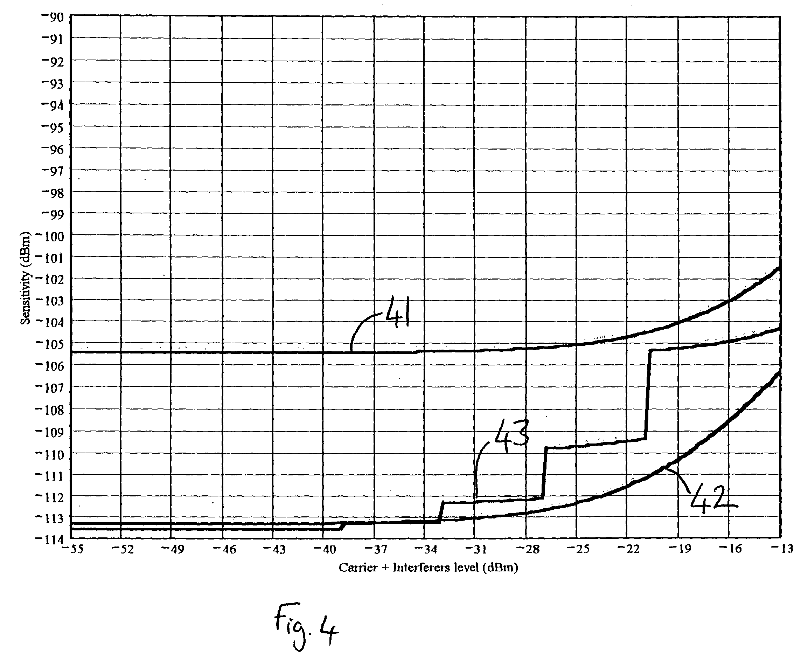

Figs. 4 to 7 show simulated results with a variety of interferers. In all these figures line 41 represents a receiver which meets the ETSI recommendations, 42 represents a conventional narrow band receiver, and 43 represents a multi-carrier receiver in accordance with the present invention. The X axis represents the combined power in dBm of the carrier frequency plus the interferer.

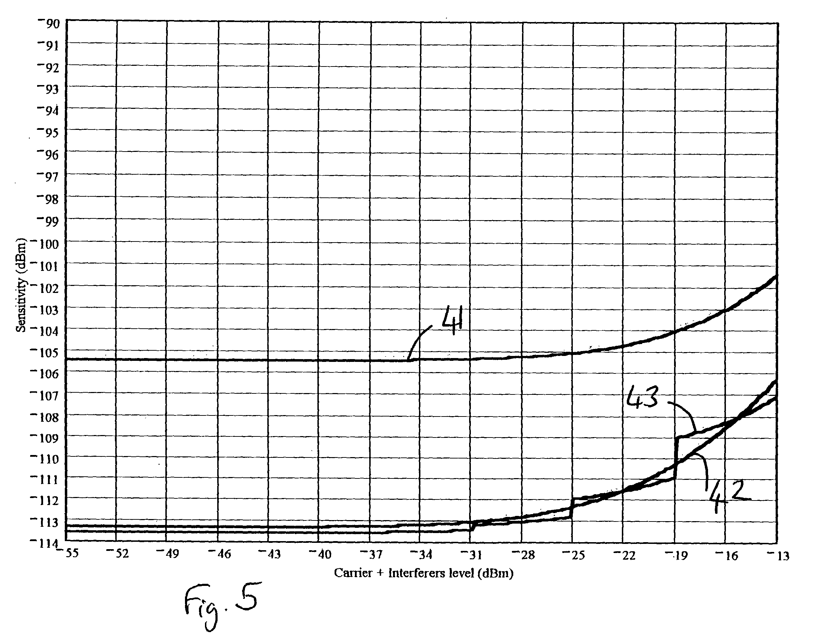

It is desirable if the BTS sensitivity is not degraded by more than 3 dB in face of an interferer whose level is given in ETSI GSM recommendation 05.05, "Radio Transmission and Reception". In a first simulation, an interferer is assumed to be either in-band (Fig. 4) or out-of-band (Fig. 5) and to be phase noise free. For both coordinated and uncoordinated interferers the receiver in accordance with the present invention stays within the ETSI requirements. In the simulation of Fig. 4 the in-band interferer power level cannot be minimized by changing the frequency of a local oscillator. Hence, the control is only by step changes in the attenuator. These steps can be seen clearly in Fig. 4. Where the received frequency band may be modified (out-of-band interferer) as shown in Fig. 5, considerable improvement can be obtained such that the performance of the receiver in accordance with the present invention is close to that of a convention narrow band receiver.

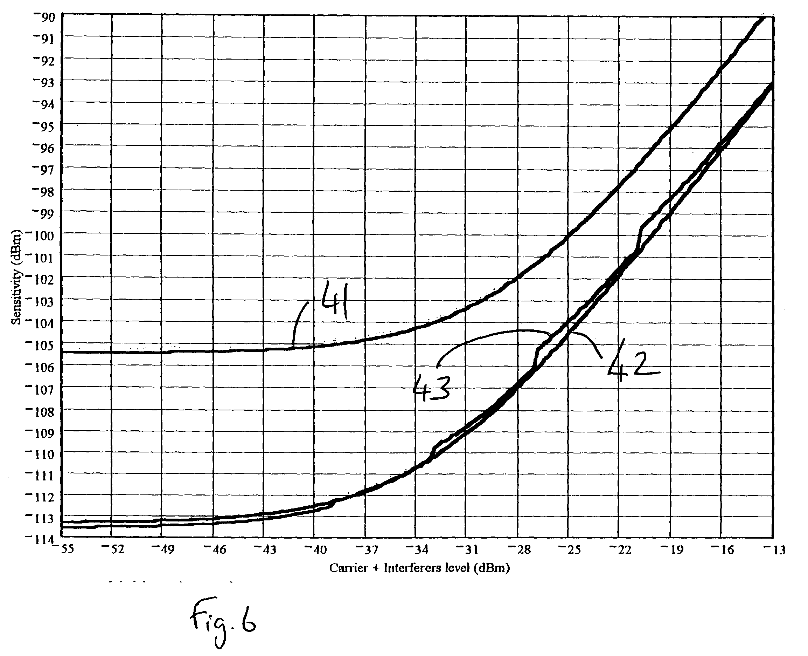

Figs. 6 and 7 show similar simulations but with the interferer having phase noise. This is the most realistic case. For an interferer with phase noise there is considerable energy in frequencies well away from the main frequency. Where power is present in frequencies lying outside the in-band range of the receiver, the frequency optimization method of the present invention allows some improvement of performance even for an in-band interferer. In this case, interferer power can be placed in out-of-band frequencies by feed back control of the local oscillator. This can be seen in Fig. 6 where there is almost no difference between a conventional narrow band receiver and the receiver in accordance with the present invention. The performance shown in Fig. 7 is exceptionally good, there is almost no distinction between the conventional narrow band receiver and the receiver in accordance with the present invention.

## Claims

1. A multi-carrier receiver for a radio telecommunications network, comprising:

   a downconverter for downconverting a received analog radio frequency signal to an intermediate frequency (IF) signal;
   a control unit for controlling the power level of the IF signal
   a coupler for coupling a representative value of the IF signal to the control unit;
   a delay element located downstream of the coupler for delaying the propagation of the IF signal to an electrical component, the control unit controlling the power level of the IF signal by feed forward control to keep this IF power level within a dynamic range of the electrical component.

2. The miulti-carrier receiver according to claim 1, wherein the electrical component is first analog to digital converter (ADC).

3. The multi-carrier receiver according to claim 1 or 2, wherein the control unit comprises a log amplifier and a second ADC.

4. The multi-carrier receiver according to any of the claims 1 to 3, wherein the delay element is a filter.

5. The multi-carrier receiver according to any previous claim wherein the control unit controls the frequency bandwidth of the IF signal so that at least a portion of the energy from an interferer lies outside the frequency bandwidth of the IF signal.

6. The multi-carrier receiver according to claim 5, wherein the control unit is adapted to adjust the operation of a local oscillator.

7. The multi-carrier receiver according to any previous claim, further comprising a device for estimating the frequency of an interferer.

8. The multi-carrier receiver according to claim 7, wherein the device estimates the frequency from the most significant bit of the output of the first ADC.

9. A method of controlling the operation of a multi-carrier receiver for a radio telecommunications network, the method comprising the steps of:

   downconverting a received analog radio frequency signal to an intermediate frequency (IF) signal;
   controlling the power level of the IF signal;
   delaying the propagation of the IF signal to a downstream electrical component, the controlling step controlling the power level of the IF signal by feed forward control to keep this IF power level within a dynamic range of the electrical component.

10. The method according to claim 9, further comprising the step of controlling the frequency bandwidth of the IF signal so that at least a portion of the energy from an interferer lies outside the frequency bandwidth of the IF signal.

11. The method according to claim 10, further comprising the step of analog to digital conversion and estimating the frequency of the interferer from the output of the conversion.

12. Use of feed forward control to limit the gain of the RF chain of a multi-carrier receiver.

ANTENNA SYSTEM → RF CHAIN → DIGITAL

Fig. 1A

Duplexer 22 → LNA 23 → 25 (mixer) → Filter 26 → Filter 27 → Variable Gain 28 → ADC 29 → Signal processing 31

RF Local Oscillator 24

Gain and Frequency selection system 30

20

Sign — Gain setting — Channels information

Gain setting — Power detection — Frequency setting

Fig. 2

EP 1 170 860 A1

ADC : Analog to Digital Converter
IF : Intermediate Frequency
RF : Radio Frequency
RXD : Diverse Receiver
RXM : Main Receiver

$Im_1$
$Qm_1$
Channelizer 1-1

$Im_{n/2}$
$Qm_{n/2}$
Channelizer 1-N

$Id_1$
$Qd_1$
Channelizer 2-1

$Id_{n/2}$
$Qd_{n/2}$
Channelizer 2-N

3 ADC
5 IF Filter
7 IF Mixer
9 RX Sub-band Filter
11 RF Mixer — RXM

13 RX IF Synthesizer
14 RX RF Synthesizer

4 ADC
6 IF Filter
8 IF Mixer
10 RX Sub-band Filter
12 RF Mixer — RXD

Fig. 1B

Fig. 3

Fig. 4

Fig. 5

Fig. 6

EP 1 170 860 A1

| | European Patent Office | EUROPEAN SEARCH REPORT | Application Number<br>EP 00 40 1835 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X<br><br>A | US 5 862 459 A (CHARAS PHILIPPE)<br>19 January 1999 (1999-01-19)<br>* abstract *<br>* column 2, line 66 - column 3, line 22 *<br>* figures 2,4 *<br>--- | 12<br><br>1,9 | H03G3/20<br>H03F1/32 |
| X<br><br>A | EP 0 926 817 A (LUCENT TECHNOLOGIES INC)<br>30 June 1999 (1999-06-30)<br>* abstract *<br>* column 2, line 58 - column 3, line 57 *<br>--- | 12<br><br>1,9 | |
| A | US 5 740 524 A (TAN WEI LEN  ET AL)<br>14 April 1998 (1998-04-14)<br>* column 2, line 10 - line 30 *<br>* column 3, line 45 - column 6, line 12 *<br>* figures 1-3 *<br>--- | 1,9,12 | |
| A | US 5 451 948 A (JEKEL RICHARD N)<br>19 September 1995 (1995-09-19)<br>* abstract *<br>* column 1, line 46 - column 3, line 13 *<br>* column 4, line 58 - column 5, line 61 *<br>* figures 1-3 *<br>----- | 1,9,12 | TECHNICAL FIELDS SEARCHED (Int.Cl.7)<br><br>H03G<br>H04B<br>H03F |

The present search report has been drawn up for all claims

| Place of search | Date of completion of the search | Examiner |
|---|---|---|
| THE HAGUE | 29 November 2000 | López Márquez, T |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

13

**ANNEX TO THE EUROPEAN SEARCH REPORT
ON EUROPEAN PATENT APPLICATION NO.**

EP 00 40 1835

This annex lists the patent family members relating to the patent documents cited in the above-mentioned European search report.
The members are as contained in the European Patent Office EDP file on
The European Patent Office is in no way liable for these particulars which are merely given for the purpose of information.

29-11-2000

| Patent document cited in search report | | Publication date | Patent family member(s) | | Publication date |
|---|---|---|---|---|---|
| US 5862459 | A | 19-01-1999 | AU | 3877197 A | 19-03-1998 |
| | | | CN | 1233358 A | 27-10-1999 |
| | | | DE | 19781955 T | 09-09-1999 |
| | | | GB | 2332316 A | 16-06-1999 |
| | | | WO | 9809372 A | 05-03-1998 |
| | | | SE | 9900650 A | 27-04-1999 |
| EP 0926817 | A | 30-06-1999 | US | 6057733 A | 02-05-2000 |
| | | | CN | 1237826 A | 08-12-1999 |
| | | | JP | 11266122 A | 28-09-1999 |
| US 5740524 | A | 14-04-1998 | US | 5564092 A | 08-10-1996 |
| | | | EP | 0807338 A | 19-11-1997 |
| | | | JP | 10513017 T | 08-12-1998 |
| | | | WO | 9614693 A | 17-05-1996 |
| | | | US | 5535444 A | 09-07-1996 |
| US 5451948 | A | 19-09-1995 | NONE | | |

EPO FORM P0459

For more details about this annex : see Official Journal of the European Patent Office, No. 12/82